# EUROPÄISCHE PATENTSCHRIFT

(11) **EP 1 816 232 B1**
(45) Veröffentlichungstag und Bekanntmachung des Hinweises auf die Patenterteilung: **25.01.2012**
(21) Anmeldenummer: 07001954.2
(22) Anmeldetag: 30.01.2007
(51) Int. Cl.: C23C 14/24

(54) **Verfahren zum allseitigen Beschichten von Gegenständen**
Method for all-round coating of objects
Procédé destiné au revêtement d'objets sur toutes les faces

(30) Priorität: 31.01.2006 DE 102006004702
(43) Veröffentlichungstag der Anmeldung: 08.08.2007
(73) Patentinhaber: COTEC GmbH, 63791 Karlstein (DE)
(72) Erfinder: Grünwald, Heinrich, Dr., 61194 Niddatal (DE); Fliedner, Michael, 63486 Bruchköbel (DE)
(74) Vertreter: Stoffregen, Hans-Herbert

(56) Entgegenhaltungen:
- EP-A- 1 013 794
- EP-A1- 0 463 230
- EP-A1- 0 933 445
- EP-A2- 0 752 482
- WO-A-00/23636
- FR-A1- 2 576 916

## Beschreibung

Die Erfindung bezieht sich auf ein Verfahren zum allseitigen Beschichten von Gegenständen, welche in einer Prozesskammer einem von zumindest einer Materialquelle ausgehenden Materialdampf und/oder -nebel ausgesetzt sind, wobei der Materialdampf und/oder -nebel durch aktive und/oder passive Mittel innerhalb der Prozesskammer verteilt und/oder abgelenkt wird.

Ein Verfahren dieser Art ist in der EP 0 933 445 A1 beschrieben. Dabei werden in einem Gasphasenbeschichtungsverfahren zur Beschichtung von Turbinenschaufeln oder Gehäuseteilen ein oder mehrere zu beschichtende Werkstücke in einem Behälter angeordnet, der geheizt wird. Über ein Treibgasrohr wird dem Behälter Treibgas zugeführt. Ein Spenderstoff ist zusammen mit einem Aktivator am Boden des Behälters angeordnet und bildet ein Beschichtungsgas, das durch Mittel zur Umwälzung, beispielsweise eine Venturidüse, aus der das Treibgas austritt, im Innern des Behälters pulsartig umgewälzt wird.

In der FR 2576916 A, EP 1013794 A2 sowie WO 00/23636 werden Verfahren beschrieben, bei denen jeweils ein Trägergas in eine Prozesskammer eingeleitet wird, welches sodann nach Umströmen der Gegenstände aus der Prozesskammer abgesaugt wird. Diese Vorrichtungen und Verfahren sind allerdings mit einem erhöhten apparativen Aufwand verbunden.

In der EP 0 752 482 A2 ist ein Verfahren und eine Vorrichtung zur Aufbringung einer widerstandsfähigen Beschichtung auf Gegenstände in einem Hochvakuum beschrieben. Bei dieser Ausführungsform ist im oberen Bereich der Prozesskammer ein Ventilator angeordnet, welcher einen Materialdampf innerhalb der Prozesskammer verteilt.

Die EP 0 463 230 A1 offenbart eine Vorrichtung zum Beschichten von Substraten in einer Vakuumkammer mit einem in dieser angeordneten Substratträger und eine Einrichtung zur Erzeugung einer Plasmawolke und mit Magneten, die die Plasmawolke auf die Oberfläche der Substrate lenken. Dabei weist die Einrichtung zur Erzeugung der Plasmawolke einen Elektronenemitter mit einer nachgeschalteten rohrförmigen Anode auf. Auch diese Ausführungsform ist mit einem erhöhten apparativen Aufwand verbunden.

Eine Beschichtungsanlage zum allseitigen Beschichten von Substraten durch Rotation der Substrate in einem Materialstrom ist beispielsweise in der DE 28 13 180 C1 beschrieben. Die Beschichtungsanlage besteht aus einer Vakuumkammer mit einer langgestreckten Materialquelle mit einer Längsachse und einer Querachse, aus einem Substrathalter mit mehreren Befestigungsstellen für die flächige Anordnung mehrerer Substrate oberhalb der Materialquelle und aus einem dem Substrathalter zugeordneten Antrieb für die Erzeugung einer Rotationsbewegung der Substrate. Dabei handelt es sich um einen mechanisch aufwändigen Substrathalter mit mehreren Rotationsachsen, der kostenaufwändig und zur Beschichtung größerer Gegenstände ungeeignet ist.

In der DE 196 43 702 A1 ist eine weitere Vakuumbeschichtungsvorrichtung zum allseitigen Beschichten eines Substrats durch Rotation des Substrats im Materialstrom beschrieben. Auch diese Vorrichtung besteht aus einer Vakuumkammer mit einer Materialquelle, aus einem Substrathalter mit einer Befestigungsstelle für die Halterung des Substrates gegenüber der Materialquelle und aus einem dem Substrathalter zugeordneten Antrieb. Für die Erzeugung einer Rotations- und Verschiebebewegung des Substrates ist der Substrathalter aus einem in drei sich winklig zueinander erstreckenden Schenkeln aufgeteilten Hohlprofilzuschnitt gebildet, wobei der erste mit dem zweiten Schenkel einen stumpfen Winkel einschließt und der zweite und dritte Schenkel zusammen ein etwa rechtwinkliges Knie bilden. Dabei wird das Substrat am Ende des dritten Schenkels gehalten, wobei der Substrathalter motorisch angetrieben um die Längsachse des ersten Schenkels rotierbar und darüber hinaus in Richtung dieser Längsachse hin- und her bewegbar ist. Neben einer ebenfalls recht aufwändigen mechanischen Rotationsanordnung ist die bekannte Vakuumbeschichtungsvorrichtung lediglich zum Beschichten eines einzelnen Substrats geeignet.

In der DE 20 2005 008 165 U 1 ist eine Vorrichtung zum beidseitigen Beschichten von Substraten beschrieben. Diese weist zumindest eine Vakuumkammer mit einem Substrathalter zur Aufnahme zumindest eines Substrates und einen gegenüber der Vorderseite des Substrates angeordneten ersten Verdampfer auf und ist dadurch gekennzeichnet, dass in der Vakuumkammer zumindest ein zweiter Verdampfer gegenüber der Rückseite eines aufgenommenen Substrates angeordnet ist. Der zweite Verdampfer ist als korbartiger Drahtbehälter mit einem Strahlblech zur Lenkung von verdampftem Material in Richtung des Substrates ausgebildet. Das Strahlblech ist in der eingezeichneten Form allerdings nur dann wirksam, wenn dieses einerseits eine hohe Temperatur aufweist, die der Verdampfertemperatur entspricht, und andererseits in der Vakuumkammer ein Hochvakuum herrscht, da nur dann der Materialdampf an dem Strahlblech "reflektiert" wird.

Ein weiteres Verfahren und eine Vorrichtung zum Beschichten von Substraten ist in der DE 42 39 511 A1 beschrieben. Die Vorrichtung umfasst eine Vakuumkammer mit einem in dieser angeordneten Substratträger und einer Einrichtung zur Erzeugung einer Plasmawolke und mit Magneten, die die Plasmawolke auf die Oberfläche der Substrate lenken. Bei diesem Verfahren werden jedoch nur die der Materialquelle zugewandten Oberflächen der Substrate beschichtet.

Eine Beschichtungseinrichtung zur Beschichtung großer Substrate ist aus der DE 202 20 798 U1 bekannt. Dabei ist in der Vakuumkammer einer Vakuumbeschichtungsanlage eine Verdampferblende sowie eine Messeinrichtung zur Bestimmung der Verdampfungsgeschwindigkeit angeordnet. Um eine homogene Reflexionsschicht definiert und effektiv auf die zu beschichtende Oberfläche aufzudampfen, ist die Beschichtungseinrichtung innerhalb der Vakuumkammer an mindestens einem Festpunkt gelagert und weist mindestens eine Bewegungseinrichtung auf, an der mindestens ein Verdampfer derart angeordnet ist, dass er gegenüber dem Festpunkt bewegbar ist. Auch diese Vorrichtung ist lediglich zum Beschichten einer der Verdampferquelle zugewandten Oberfläche des Substrates geeignet.

Obiger Stand der Technik zeigt, dass das Auftragen dünner Schichten durch Bedampfen seit langem bekannt ist. Hierbei wird ein meist festes Material mit niedrigem Dampfdruck, beispielsweise ein Metall oder ein Metalloxid, üblicherweise unter Hochvakuum im Bereich < 0,1 Pa in einer Verdampferquelle so hoch erhitzt, dass es verdampft. Hierbei kondensiert der Materialdampf an den, verglichen mit der Verdampferquelle kalten Oberflächen der zu beschichtenden Substrate bzw. Werkstücke und den Wänden der Vakuumkammer, wobei sich die gewünschte Schicht des Feststoffes bildet. Unter diesen Bedingungen breitet sich der Materialdampf nahezu geradlinig von der Verdampferquelle her üblicherweise nach oben aus, so dass im Wesentlichen nur die der Verdampferquelle zugewandten Bereiche der Werkstückoberflächen beschichtet werden.

Dies ist nachteilig, wenn die gesamte Werkstückoberfläche beschichtet werden soll. Zur Erzielung einer allseitigen Beschichtung müssen die Werkstücke wie oben erwähnt gewendet oder innerhalb der Dampfwolke gedreht werden, was in der Produktion zusätzlich zu einem erhöhten apparativen sowie zu einem besonderen personellen Aufwand führt, da die Werkstücke hierzu fixiert werden müssen.

Das Bedampfen von Schüttgut oder Haufwerken ist nach diesen Verfahren besonders aufwändig, da diese kaum wirtschaftlich oberhalb der Verdampferquelle zu fixieren sind. Die DD 234 175 A1 beschreibt eine Einrichtung zur plasmagestützten Vakuumbeschichtung von Schüttgütern, wobei die Schüttgüter innerhalb einer rotierenden Substrattrommel mit durchbrochenem Trommelmantel angeordnet sind. Dabei ist vorgesehen, dass im Bereich des Trommelmantels und damit der Schüttgüter eine erhöhte Anregung der Ionen und atomaren Teilchen erfolgt. Die Materialien müssen während des Bedampfungsvorgangs umgewälzt werden. Nachteile ergeben sich hierbei aus der Beschichtung der Drehkörbe, da diese beim Erreichen einer kritischen Schichtdicke zum Abplatzen unter Staubbildung neigt. Alternativ kann der von der Verdampferquelle nach oben austretende Materialdampf durch sehr heiße Flächen nach unten umgelenkt werden, was aber sehr aufwändig ist.

Andererseits sind auch Vorrichtungen und Verfahren bekannt, mit denen Werkstücke durch Aufdampfen allseitig mit Schichten überzogen werden können. Hierzu werden die Werkstücke in einer Vakuumkammer unter Fein- oder Grobvakuum im Bereich von 0,1 bis 100 Pa bzw. > 100 Pa mit einem Material, das einen höheren Dampfdruck (im Bereich > 1 Pa bei 292 K) aufweist, bedampft. Aufgrund der in diesem Druckbereich wesentlich höheren Dichte an Teilchen in der Gasphase kann sich der von der Verdampferquelle ausgehende Dampf nicht mehr geradlinig ausbreiten, sondern wird durch Kollision mit den Teilchen in der Gasphase gestreut. Aufgrund dieses Effekts ist unter diesen Bedingungen eine Beschichtung von Werkstücken auch auf der Seite möglich, die der Verdampferquelle abgewandt ist.

Es hat sich allerdings herausgestellt, dass die Gleichmäßigkeit der Schichtdicke beispielsweise über eine Vielzahl von Werkstücken auf einen oder mehrere Träger hinweg begrenzt ist. Sie ist für Aufdampfmaterialien mit niedrigem Dampfdruck im Bereich < 0,1 Pa für optische Anwendungen oftmals nicht mehr ausreichend, wenn eine größere Anzahl von Werkstücken gleichzeitig bedampft werden soll.

Aus der US 6,013,319 A ist ein Verfahren und eine Vorrichtung zur Verbesserung der Ablagerungsqualität eines chemischen Dampfes auf einem Substrat beschrieben. Dabei wird innerhalb einer Verdampferkammer ein Dampfstrom erzeugt, der jedoch nur einseitig an dem zu beschichtenden Material mittels Umlenkplatten vorbeigeleitet wird.

In der DE 970 970 B ist eine Einrichtung zum Herstellen von Oberflächenschichten durch Verdampfen oder Sublimieren eines Überzugstoffes im Hochvakuum beschrieben. Dabei sind die zu überziehenden Gegenstände unter einem Schiffchen angeordnet, wobei der aus dem Schiffchen zunächst nach oben austretende Atom- oder Molekülstrahl durch eine oder mehrere beheizte Flächen in seiner Richtung so abgelenkt wird, dass er anschließend seinen Weg von oben nach unten in Richtung auf die zu überziehenden Gegenstände fortsetzt. Auch bei diesem Verfahren wird der Gegenstand lediglich einseitig beschichtet.

In der GB 1 299 274 A ist ein Verfahren und eine Vorrichtung zur Beschichtung mit luft-permeablen Materialien beschrieben. Dabei wird durch Unterdruck das Beschichtungsmaterial in luftdurchlässige Fasern gesaugt und wird dort aufgeschmelzt.

Schließlich wird in der EP 1 247 587 A2 ein Verfahren und eine Vorrichtung zum Behandeln und/oder Beschichten einer Fläche eines Gegenstandes beschrieben, wobei durch Einwirken der Schwerkraft durch Konvektion eine homogene Beschichtung auf einer Fläche erreicht wird.

Davon ausgehend liegt der vorliegenden Erfindung die Aufgabe zu Grunde, ein Verfahren der eingangs genannten Art dahingehend weiterzubilden, um eine allseitig gleichmäßige Beschichtung von einzelnen oder in Chargen angeordneten Gegenständen bei einfachem apparativem Aufbau zu ermöglichen.

Die Aufgabe wird verfahrensmäßig dadurch gelöst, dass innerhalb der ein Hintergrundgas aufweisenden Prozesskammer ein eine viskose Strömung zulassendes Vakuum eingestellt wird, dass ein bei Raumtemperatur flüssiges oder festes und bei einer Temperatur von 550 K bis 670 K einen Dampfdruck > 1 Pa aufweisendes Material in der als Verdampfungsquelle ausgebildeten Materialquelle verdampft wird und dass der aus der zumindest einen Verdampfungsquelle austretende Materialdampf und/oder -nebel zusammen mit dem Hintergrundgas durch die aktiven und/oder passiven Mittel derart verteilt und/oder abgelenkt wird, dass eine die Gegenstände allseitig umströmende, gerichtete viskose Materialströmung erzeugt wird.

Im Gegensatz zu den aus dem Stand der Technik bekannten Lösungen liegt der Erfindung die Idee zu Grunde, innerhalb der Prozesskammer mit aktiven und/oder passiven Mitteln den aus der Materialquelle austretenden Materialdampf und/oder -nebel in eine die Gegenstände allseitig umströmende und somit allseitig gleichmäßig beschichtende Materialströmung zu überführen. Hierbei ist es nicht notwendig, die Gegenstände relativ zur Materialquelle zu bewegen. Auch eine Bewegung der Materialquelle ist nicht zwingend notwendig. Die Gegenstände werden nicht nur in Sichtlinie der Materialquelle beschichtet, sondern auch umseitig. Es können auch räumlich (nicht nur flächig) angeordnete Chargen von Gegenständen beschichtet werden, ohne dass diese in aufwändigen Drehvorrichtungen angeordnet sind. Die Ausnutzung der Bedampfungsvorrichtung wird insgesamt stark verbessert.

Erfindungsgemäß kann das zu verdampfende Material bei Raumtemperatur ein Feststoff oder eine Flüssigkeit sein, mit einem Dampfdruck bei Zimmertemperatur in Höhe von 10⁻⁴ Pa bis 5000 Pa, vorzugsweise 10⁻³ bis 10 Pa.

Gemäß einer bevorzugten Verfahrensweise wird innerhalb der Prozesskammer während der Bedampfung ein Vakuum im Bereich von 10 Pa bis 1050 hPa, vorzugsweise 10 hPa - 500 hPa, eingestellt, so dass sich für das Produkt aus Druck und der kleinsten Dimension der Beschichtungskammer ein Wert von 1 Pam bis 500 000 Pam , vorzugsweise 1000 Pam ergibt. Unter diesen Bedingungen liegt eine genügende Gasviskosität als Voraussetzung zur Durchführung des Verfahrens vor.

Beispielsweise kann durch Einleiten eines Hintergrundgases wie beispielsweise des Inertgases Argon im Anschluss an eine Evakuierung der Prozesskammer ein Vakuum innerhalb der Prozesskammer derart eingestellt werden, dass sich eine viskose Materialströmung in Verbindung mit den aktiven und/oder passiven Mitteln einstellen kann. Bei einer viskosen Strömung bleibt die mittlere Weglänge *l̅* klein im Vergleich zu den Dimensionen des von dem Gas durchströmten Raumes (*l̅* << Dimension) so dass das Gas als Kontinuum betrachtet werden kann. Diese sogenannte viskose Strömung teilt sich in zwei Strömungsformen auf, nämliche einerseits eine laminare Strömung mit einer Reynoldszahl < 2200 und andererseits eine turbulente Strömung mit einer Reynoldszahl > 2200.

Bei der Erfindung wird der Effekt ausgenutzt, dass bei der Evakuierung - je nach Verhältnis der inneren Dimensionen der Anlagenbauteile zur mittleren freien Weglänge der strömenden Gasteilchen - verschiedene Strömungsarten auftreten. Durch hohe Reynoldszahlen gekennzeichnete turbulente Strömungen treten dabei im Allgemeinen nicht auf. Bei der Evakuierung herrscht zunächst laminare Strömung, die bei dem erfindungsgemäßen Verfahren ausgenutzt wird. Mit Absinken des Druckes innerhalb der Prozesskammer tritt Knudsen-Strömung und schließlich Molekularströmung auf, was bei den Verfahren nach dem Stand der Technik zwar gewünscht, jedoch bei der vorliegenden Erfindung vermieden werden soll.

Die gewünschte Gasviskosität bildet sich im Feinvakuum je nach Art des Gases zwischen 10 Pa und 100 Pa, bevorzugt aber im Grobvakuum oberhalb 100 Pa oder bei noch höherem Druck nahe oder, jedoch weniger bevorzugt, über 1 Bar aus. Jedoch ist ein zu hoher Druck und eine damit einhergehende höhere Gasviskosität unter Umständen von Nachteil, da sich hierbei Strömungsmuster des Dampfes bzw. Nebels ausbilden können, derart, dass nicht die gesamte Fläche des zu beschichtenden Gegenstandes in gleicher Weise beschichtet wird.

In einer bevorzugten Ausführungsform werden als passive Mittel zur Verteilung und/oder Ablenkung des Materialdampfes Blenden in Form von offenen, siebförmigen, gelochten, ebenen oder gebogenen flächigen Elementen wie Lochblechen und/oder Umlenkstrukturen in Form von offenen, siebförmigen, gelochten oder geschlossenen ebenen oder gebogenen flächigen Elementen wie Lochblechen oder Blechen verwendet. Hierbei hat sich gezeigt, dass geschlossene Blenden, die lediglich die zu beschichtenden Teile gegenüber der als Verdampferquelle ausgebildeten Materialquelle abschatten, im Sinne der Aufgabe nicht ausreichend effektiv sind, da sie einerseits in unerwünschter Weise Beschichtungsmaterial sammeln und andererseits einen "Dampfschatten", innerhalb dessen nur wenig Beschichtung aufgebracht wird, ausbilden. Daher werden gemäß der Erfindung allgemein durchbrochene, beispielsweise gelochte Blenden verwendet. Innerhalb des erfindungsgemäß gewählten Druckbereichs kann der von der Verdampferquelle aufsteigende Materialdampf oder Materialnebel mit statisch angebrachten Umlenkstrukturen umgelenkt werden. Im einfachsten Fall eignen sich hierzu ebene oder gebogene flächige Elemente wie Bleche. Im Gegensatz zum Stand der Technik werden die Umlenkstrukturen nicht beheizt, sondern weisen die Temperatur der Prozesskammer auf. Erfindungsgemäß wird durch die viskose Strömung verhindert, dass der Materialdampf an den passiven Mitteln zu sehr kondensiert.

Das Verfahren zeichnet sich des Weiteren dadurch aus, dass der Materialdampf durch aktive Mittel verteilt und/oder abgelenkt wird. Als besonders wirksam haben sich von außen in die Prozesskammer eingeführte Gasströme erwiesen, welche vorzugsweise im Grobvakuum auf effiziente Weise eine Verteilung und/oder Ablenkung des Materialdampfes oder -nebels bewirken. Besonders vorteilhaft ist, dass eine hierzu erforderliche Anordnung innerhalb der Prozesskammer sich im Wesentlichen auf eine oder mehrere Einlassdüsen beschränkt und somit wenig Platz beansprucht. Gemäß einem bevorzugten Verfahren werden Einlassdüsen um die Materialquelle herum mit Blasrichtung radial zum Verdampfer hin angeordnet, wobei die Düsen der Reihe nach einzeln oder in Gruppen mit einer Periode im Bereich von 0,03 s bis 120 s, vorzugsweise 1 geöffnet werden.

Des Weiteren ist vorgesehen, dass im Grobvakuum eine Verteilung und Ablenkung des Materialdampfes durch Ventilatoren bzw. Gebläse durchgeführt wird.

Auch besteht die Möglichkeit, innerhalb der Prozesskammer eine Materialströmung durch Abpumpen zu erzeugen, wobei die Strömung den Materialdampf bei der Beschichtung bewegt und ablenkt.

Die oben erläuterten Verfahren zur Lenkung und Verteilung des Materialdampfes können einzeln oder in Kombination miteinander eingesetzt werden. Beispielsweise können durchbrochene Blenden auch als Umlenkbleche ausgeformt oder bewegte Verdampferquellen mit Ventilatoren kombiniert werden.

Im Rahmen der Erfindung können auch zusätzlich zu den genannten Mitteln zur Lenkung und Verteilung des Dampfes die als solche bekannten Maßnahmen zur Verbesserung der Schichtdickengleichmäßigkeit durch Bewegung des zu beschichtenden Gegenstandes getroffen werden. Hierzu zählen die Linearbewegung und insbesondere das Rotieren von Werkstücken und das Umwälzen von Schüttgütern oder Haufwerken in Trommeln oder Förderschnecken. Auch kann die Verdampferquelle bewegt werden, entweder linear oder exzentrisch rotierend.

Das Verdampfen aus der Verdampfungsquelle kann grundsätzlich mit den in der Bedampfungstechnik üblichen Methoden geschehen. Angesichts des vergleichsweise hohen Drucks in der Prozesskammer und aus Kostengründen wird jedoch bevorzugt, das zu verdampfende Material aus einem Verdampfungsgefäß, beispielsweise einem Tiegel oder Schiffchen, herauszuverdampfen, das mit einer elektrischen Widerstandsbeheizung beheizt wird. Ebenso ist es möglich, das Material mit einem Laserstrahl zu verdampfen.

Die Verdampfungsquelle kann diskontinuierlich oder kontinuierlich mit dem zu verdampfenden Material beschickt werden. Zur diskontinuierlichen Beschickung wird das zu verdampfende Material bevorzugt in Festportionen als Granulat, Pressling oder Sinterkörpern in die Verdampferquelle eingelegt. Flüssiges, zu verdampfendes Material in kleinen Mengen wird hierzu von saugfähigen, chemisch inerten und über der eingestellten Verdampfungstemperatur nicht verdampfenden Trägermaterialien aufgenommen, die dann der Verdampferquelle zugeführt werden. Die Aufnahme von flüssigem, zu verdampfendem Material in eine geschlossene Packung wie beispielsweise eine Ampulle oder ein Beutel, die in der Verdampfungsquelle unmittelbar vor dem Verdampfen geöffnet wird, ist ebenso möglich.

Wenn größere Mengen eines flüssigen oder eines leicht sublimierenden festen Materials verdampft werden sollen, kann dieses, wenn es thermisch genügend stabil ist, auch in einem beheizten Trog vorgehalten werden. Der Dampf wird dann über die Dauer der Bedampfung durch ein Ventil aus dem Trog ausgelassen.

Wenn allgemein größere Materialmengen ohne Unterbrechung verdampft werden sollen oder das zu verdampfende Material thermisch nicht genügend stabil ist, wird die Verdampferquelle kontinuierlich beschickt. Hierzu wird kontinuierlich festes, genügend feinkörniges Material beispielsweise mit einer Förderschnecke in den Tiegel gefördert. Im Falle von flüssigem zu verdampfendem Material wird dieses über ein Dosierventil, vorzugsweise ein geregeltes Dosierventil oder eine Dosierpumpe, in den Tiegel befördert.

Weitere Einzelheiten, Vorteile und Merkmale der Erfindung ergeben sich nicht nur aus den Ansprüchen, den diesen zu entnehmenden Merkmalen -für sich und/oder in Kombination-, sondern auch aus der nachfolgenden Beschreibung von der Zeichnung zu entnehmenden bevorzugten Ausführungsbeispielen.

Es zeigen:
- Fig. 1: eine erste Ausführungsform einer Vorrichtung zum allseitigen Beschich- ten von Gegenständen,
- Fig. 2a, b: eine zweite Ausführungsform einer Beschichtungsvorrichtung,
- Fig. 3a, b: eine dritte Ausführungsform einer Beschichtungsvorrichtung,
- Fig. 4: eine vierte Ausführung einer Beschichtungsvorrichtung,
- Fig. 5: eine fünfte Ausführungsform einer Beschichtungsvorrichtung und
- Fig. 6: eine sechste Ausführungsform einer Beschichtungsvorrichtung.

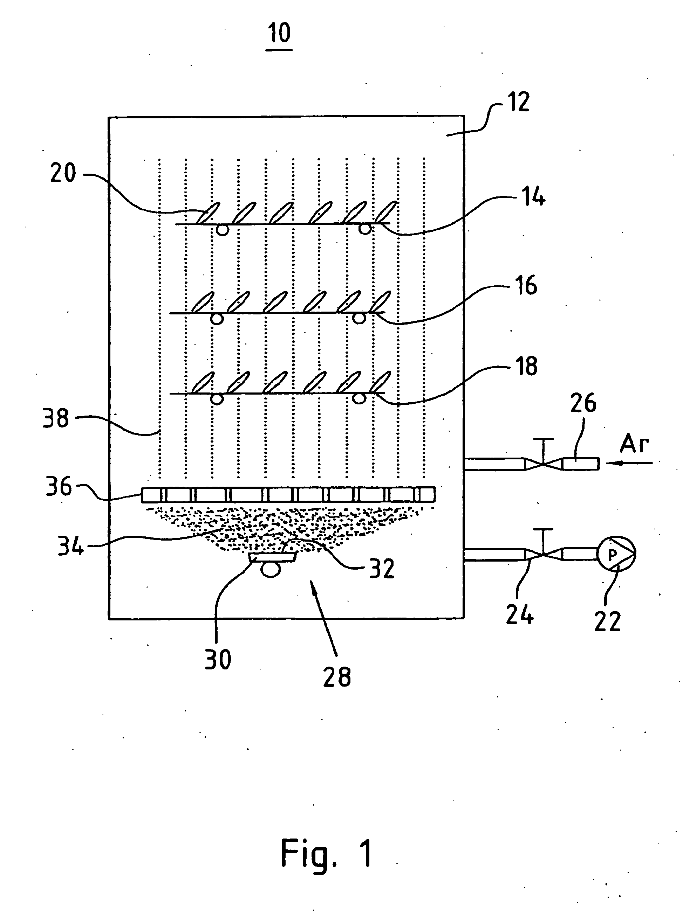

Fig. 1 zeigt rein schematisch eine erste Ausführungsform einer Beschichtungsvorrichtung 10, umfassend eine Prozesskammer 12 mit einer Breite von etwa 300 mm, einer Höhe von ca. 600 mm und einer Tiefe von etwa 350 mm mit drei übereinander angeordneten Werkzeugträgern 14, 16, 18, die mit Werkstücken 20, im vorliegenden Ausführungsbeispiel mit antireflexbeschichteten optischen Gläsern wie Brillengläsern, bestückt sind.

Die Prozesskammer 12 wird mit den optischen Gläsern 20 beschickt und verschlossen. Anschließend wird die Prozesskammer 12 mit einer Vakuumpumpe 22 auf einen Restdruck von ca. 1 Pa evakuiert und das Vakuumpumpen durch Schließen eines zwischen Vakuumpumpe 22 und Prozesskammer 12 angeordneten Ventils 24 unterbrochen. Daraufhin wird als Inertgas Argon bis zu einem Partialdruck von 1000 Pa über einen Eingang 26 eingelassen. Anschließend wird eine Materialquelle 28 in Form einer Verdampferquelle mittels eines widerstandsbeheizten Tiegels 30 auf ca. 400 K erhitzt. In dem Tiegel 30 befindet sich zu verdampfendes Material 32 in Form von organischen, siliziumorganischen und fluororganischen Substanzen mit hohem Molekulargewicht.

Durch das Beheizen des Tiegels 30 wird das vorher in den Tiegel eingebrachte Material 32, beispielsweise eine mit 100 µl Silikonöl getränkte Metallfritte, ebenfalls erhitzt und das aufgenommene Silikonöl verdampft, so dass sich eine Materialdampfwolke 34 bildet. Oberhalb der Materialquelle 28 ist ein passives Mittel 36 zur Verteilung und Umlenkung der von der Materialquelle 28 nach oben aufsteigenden Materialdampf- und Nebelwolke 34 angeordnet. Diese wird durch das passive Strömungsmittel 36, welches als Lochblech in Form einer offenen Blende ausgebildet ist, in eine gleichmäßige Materialdampfströmung 38 ausgebreitet und abgelenkt. Nach Durchqueren der offenen Blende 36 durchströmt die Materialdampfströmung die Warenträger 14, 16, 18 mit den optischen Gläsern 20 gleichmäßig und kondensiert als gleichmäßig verteilte, hydrophobe Schicht auf den optischen Gläsern, die hierdurch schmutzabweisend und leichter reinigbar werden. Nach einer Einwirkzeit des Materialdampfes von 5 Minuten wird die Beheizung des Tiegels 30 beendet, erneut auf 0,1 Pa evakuiert und anschließend belüftet, wonach die Warenträger 14, 16, 18 entnommen werden können.

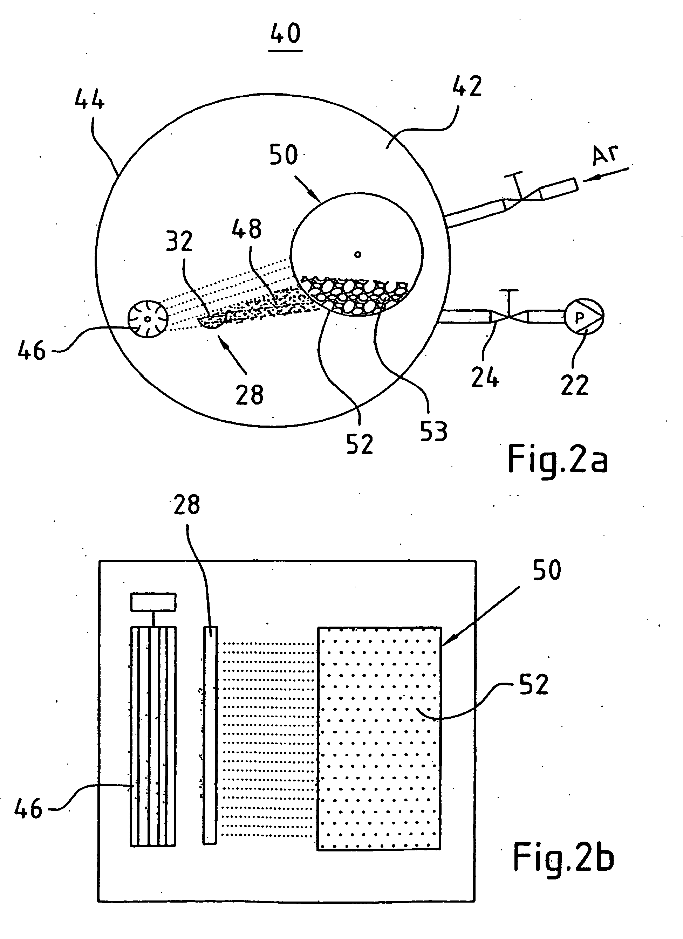

Die Fig. 2a und 2b zeigen rein schematisch eine Vorderansicht sowie eine Draufsicht einer zweiten Ausführungsform einer Beschichtungsvorrichtung 40. Diese verwendet eine zylindrische Prozesskammer 42 mit einem Durchmesser von etwa 350 mm und einer Tiefe von etwa 350 mm, deren Wandung 44 auf eine Temperatur im Bereich von 330 K geheizt wird. Die Prozesskammer wird mit der Vakuumpumpe 22 auf einen Restdruck von 0,1 Pa evakuiert und das Vakuumpumpen durch Schließen eines zwischen Vakuumpumpe 22 und Prozesskammer 42 angeordneten Ventils 24 unterbrochen. Daraufhin wird das Inertgas Argon bis zu einem Partialdruck von 25.000 Pa eingelassen. Anschließend wird die Verdampferquelle 28 erhitzt, um das Material 32 zur Erzeugung des Materialdampfes zu erhalten. Als Mittel zur Verteilung des Metallmaterialdampfes ist ein Ventilator 46, vorzugsweise ein walzenförmiger Ventilator 46, vorgesehen, der neben der Verdampferquelle 28 angeordnet und auf diese gerichtet ist. Durch die Bewegung des Ventilators 46 wird der aufsteigende Materialdampf seitlich in eine Materialströmung 48 ausgebreitet und in eine Drehtrommel 50 geführt, die auf einer entgegengesetzten Seite der Verdampferquelle 28 vorgesehen ist. Eine Wand 52 der Drehtrommel 50 ist im Wesentlichen als Gitter ausgeführt, das den Zutritt des von der Verdampferquelle 28 hergeleiteten Materialstroms 48 zu einem im Innern befindlichen und kontinuierlich durch Drehen umgewälzten Haufwerks 53 von beispielsweise Fasern zulässt. Durch die Behandlung mit dem abgedampften Silikonöl werden beispielsweise Fasern als Haufwerk 53 hydrophob ausgerüstet.

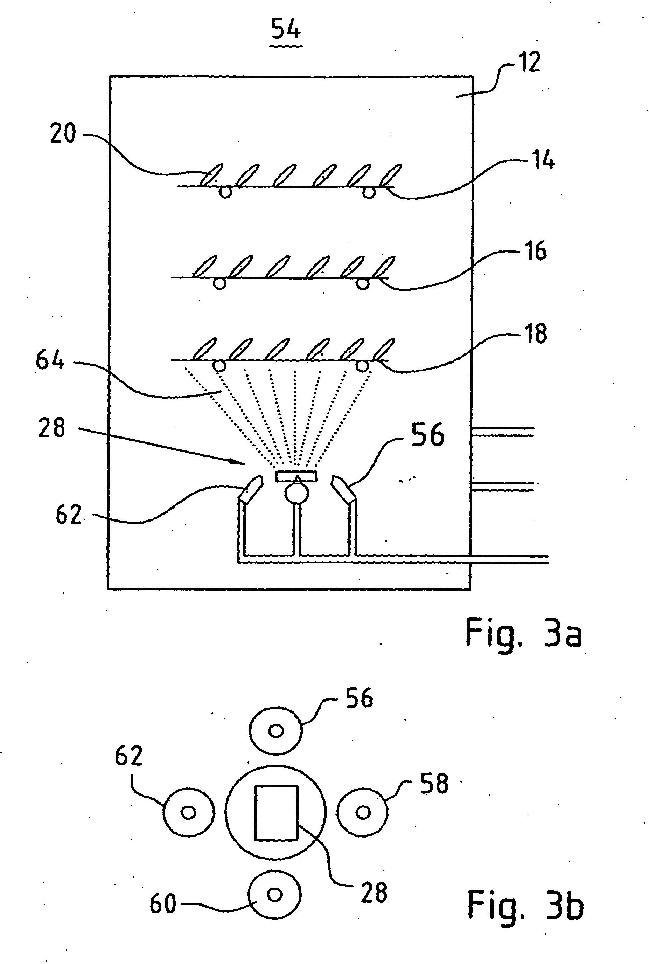

Die Figuren 3a und 3b zeigen rein schematisch eine dritte Ausführungsform einer Bedampfungsvorrichtung 54, die im Wesentlichen der Ausführungsform gemäß Fig. 1 entspricht. Diese umfasst ebenfalls eine Prozesskammer 12 mit einer Breite von etwa 300 mm, einer Höhe von ca. 600 mm und einer Tiefe von ca. 350 mm mit drei übereinander angeordneten Warenträgern 14, 16, 18, die mit Werkstücken 20, im vorliegenden Ausführungsbeispiel mit antireflexbeschichteten optischen Gläsern wie Brillengläsern enthalten sind.

Bei diesem Verfahren ist eine Wandtemperatur der Prozesskammer 12 einheitlich auf 330 K (58 °C) eingestellt. Anstatt des in Fig. 1 dargestellten Lochblechs 36 zur Verteilung des Materialdampfes 34 sind in der Ausführungsform gemäß Fig. 3 eine Vielzahl von Düsen 56, 58, 60, 62 kreisringförmig um den Verdampfer 28 herum angeordnet, mit einer Blasrichtung radial zum Verdampfer hin. Dadurch wird ein Materialstrom 64 erzeugt, welcher die zu bedampfenden Güter 20 allseitig umströmt. Bevorzugterweise werden die Düsen 56, 58, 60, 62 der Reihe nach einzeln periodisch beispielsweise in einer Periode von 1 Sekunde geöffnet.

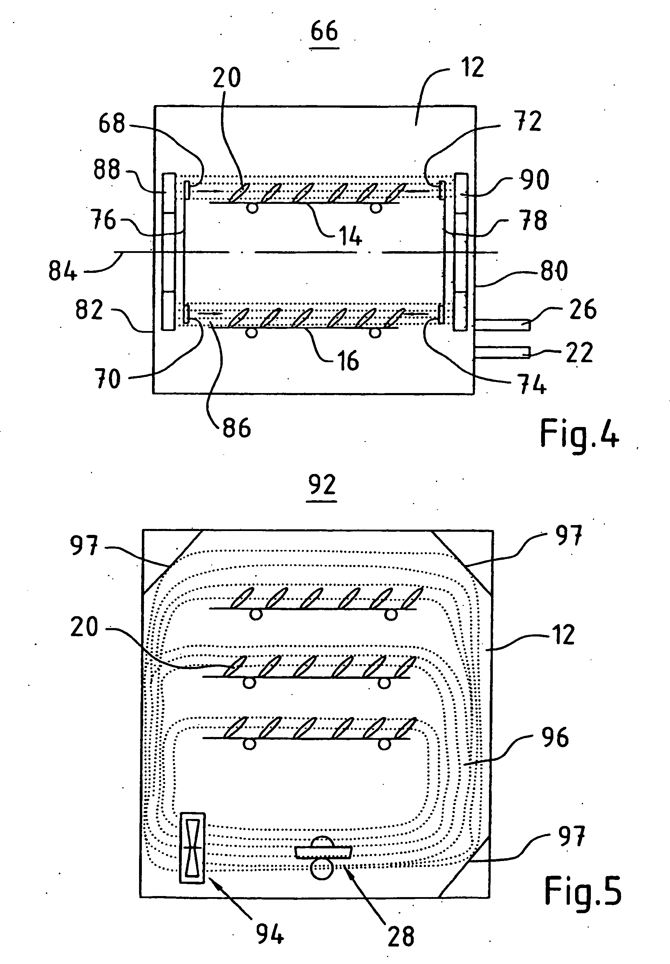

Ein weiteres Ausführungsbeispiel einer Verdampfervorrichtung 66 ist rein schematisch in Fig. 4 dargestellt. Die Vorrichtung umfasst wiederum die Prozesskammer 12 mit Halterungen 14, 16 für die zu beschichtenden Güter 20 sowie einen Anschluss für die Vakuumpumpe 22 und einen Anschluss 26 zum Einlass des Inertgases Argon. Bei dieser Ausführungsform sind je zwei Verdampfer 68, 70; 72, 74 exzentrisch und gegenüberliegend auf je einer von zwei rotierenden Halterungen 76, 78 montiert, die entlang von zwei gegenüber liegenden Seitenwänden 80, 82 innerhalb der Prozesskammer 12 um eine horizontale Achse 84 rotieren. Dabei wird der erzeugte Materialdampf 86 durch wandseitig von den Verdampfern montiere Ventilatoren 88, 90 von den zwei gegenüberliegenden Seitenwänden 80, 82 in Richtung der Mitte der Prozesskammer 12 bewegt.

Fig. 5 zeigt rein schematisch eine fünfte Ausführungsform einer Beschichtungsvorrichtung 92, bei der eine Gebläse- bzw. Ventilatoreinheit 94 seitlich des Verdampfers 28 angeordnet ist, und eine Materialdampfströmung 96 erzeugt, welche begrenzt durch Wandungen der Prozesskammer 12 und ggfs. Umlenkbleche 97 im Wesentlichen eine Ringströmung bildet, welche die zu beschichtenden Objekte 20 allseitig umströmt.

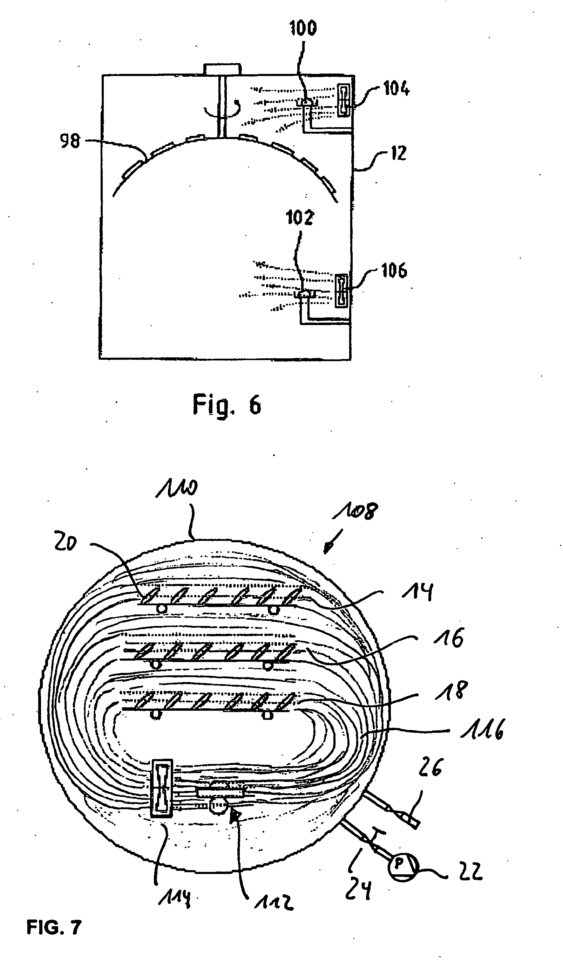

Eine weitere Ausführungsform, die in Fig. 6 dargestellt ist, zeichnet sich dadurch aus, dass beidseitig einer horizontal angeordneten Kalotte 98 je ein Verdampfer 100, 102 angeordnet wird. Die jeweilige Materialdampfwolke wird durch Ventilatoren 104, 106 verteilt und in Richtung der Kammermitte bewegt.

Fig. 7 zeigt eine weitere Ausführungsform einer Beschichtungsvorrichtung 108, wobei die Werkzeugträger 14, 16, 18 mit den Werkstücken 20 in einer zylinderförmigen Prozesskammer 110 angeordnet sind. Innerhalb der Prozesskammer 110 sind eine Verdampferquelle 112 sowie ein Ventilator 114 angeordnet, der im Innern der Prozesskammer 110 eine die Gegenstände 20 allseitig umströmende, gerichtete Viskosematerialströmung 116 erzeugt und durch die zylinderförmige Wandung der Prozesskammer 110 geleitet wird.

Durch die erfindungsgemäßen Verfahren können Formteile nicht nur in Sichtlinie des Verdampfers beschichtet, sondern auch umseitig, insbesondere allseitig, beschichtet werden. Es können auch räumlich, d. h. nicht nur flächig, angeordnete Chargen beschichtet werden. Hierbei ist es nicht notwendig, die Formteile relativ zur Verdampferquelle zu bewegen. Haufwerke und Schüttgüter können ebenfalls umseitig beschichtet werden, wobei es hier von Vorteil ist, diese relativ zur Verdampferquelle zu bewegen, beispielsweise in einer Trommel, wie in Fig. 2 dargestellt, umzuwälzen. Insgesamt wird durch das erfindungsgernäße Verfahren und die beschriebenen Vorrichtungen die Ausnutzung der Bedampfungsvorrichtung stark verbessert. Das Verfahren kann in einem Fein- oder vorzugsweise einem Grobvakuum, ausgeführt werden. Auch besteht die Möglichkeit, das Verfahren unter Atmosphärendruck auszuführen. Aus den obigen Vorteilen ergeben sich jeweils erhebliche Kostenvorteile im Vergleich zum Stand der Technik.

Erfindungsgemäß können alle bei Raumtemperatur festen und flüssigen Materialien aufgedampft werden, die bei ca. 600 K bis 670 K ohne sich zu zersetzen einen genügend hohen Dampfdruck von ca. 1 Pa haben. Beispielsweise lassen sich organische, siliziumorganische und fluororganische Substanzen mit hohem Molekulargewicht einsetzen zur Herstellung von hydrophoben Schichten, oleophoben Schichten, oleophoben und reibungsmindernden Schichten, dehäsiven Schichten, hydrophilen Schichten

## Patentansprüche

1. Verfahren zum allseitigen Beschichten von Gegenständen (20), welche in einer Prozesskammer (12, 42) einem von zumindest einer Materialquelle (28) ausgehenden Materialdampf und/oder -nebel (34) ausgesetzt sind, wobei der Materialdampf und/oder -nebel (34) durch aktive und/oder passive Mittel (36, 46, 56, 88, 90, 94) innerhalb der Prozesskammer (12, 44) verteilt und/oder abgelenkt wird,
**dadurch gekennzeichnet,**
**dass** innerhalb der ein Hintergrundgas aufweisenden Prozesskammer (12, 42) ein eine viskose Strömung zulassendes Vakuum eingestellt wird, dass ein bei Raumtemperatur flüssiges oder festes und bei einer Temperatur von 550 K bis 670 K einen Dampfdruck > 1 Pa aufweisendes Material (32) in der als Verdampfungsquelle ausgebildeten Materialquelle (28) verdampft wird und dass der aus der zumindest einen Verdampfungsquelle (28) austretende Materialdampf und/oder -nebel (34) zusammen mit dem Hintergrundgas durch die aktiven und/oder passiven Mittel (36, 46, 56, 88, 90, 94) derart verteilt und/oder abgelenkt wird, dass eine die Gegenstände (20) allseitig umströmende, gerichtete viskose Materialströmung (38, 48, 64, 86, 96) erzeugt wird.

2. Verfahren nach Anspruch 1,
**dadurch gekennzeichnet,**
**dass** innerhalb der Prozesskammer (12) während der Bedampfung ein Feinvakuum im Bereich von 10 Pa bis 100 Pa oder ein Grobvakuum oberhalb 100 Pa eingestellt wird.

3. Verfahren nach Anspruch 1 oder 2,
**dadurch gekennzeichnet,**
**dass** die Gegenstände (20) mit hydrophoben und/oder oleophoben und/oder reibungsmindernden und/oder dehäsiven und/oder hydrophilen Schichten beschichtet werden.

4. Verfahren nach zumindest einem der vorhergehenden Ansprüche,
**dadurch gekennzeichnet,**
**dass** als passive Mittel zur Verteilung und/oder Ablenkung des Materialdampfes (34) Blenden (36) in Form von offenen, siebförmigen, gelochten, ebenen oder gebogenen flächigen Elementen wie Lochblechen und/oder Umlenkstrukturen (52, 97) in Form von offenen, siebförmigen, gelochten oder geschlossenen ebenen oder gebogenen flächigen Elementen wie Lochblechen oder Blechen verwendet werden.

5. Verfahren nach zumindest einem der vorhergehenden Ansprüche,
**dadurch gekennzeichnet,**
**dass** die Materialströmung (38, 48, 64, 86, 96) durch von außen in die Prozesskammer (12) eingeführte Gasströme erzeugt wird und/oder dass von außen in die Prozesskammer eingeführte Gasströme bei Durchführung des Verfahrens im Grobvakuum eingesetzt werden und/oder dass die Gasströme über ringförmig zu der Materialquelle (28) angeordnete Düsen (56, 58, 60, 62) mit Blasrichtung radial zur als Verdampferquelle (28) ausgebildeten Materialquelle eingelassen werden und/oder
**dass** die Düsen (56, 58, 60, 62) der Reihe nach einzeln oder in Gruppen mit einer Periode im Bereich von 0,03 s bis 120 s vorzugsweise 1 s, geöffnet werden.

6. Verfahren nach zumindest einem der vorhergehenden Ansprüche,
**dadurch gekennzeichnet,**
**dass** die Materialströmung (38, 48, 64, 86, 96) durch in der Prozesskammer angeordnete Ventilatoren und/oder Gebläse (46, 88, 90) erzeugt wird und/oder dass die Materialströmung (64, 86, 96) durch Ventilatoren und/oder Gebläse (46, 88, 90, 94) in einem Grobvakuum erzeugt wird und/oder dass die Materialströmung (38, 64, 86, 96) durch Abpumpen erzeugt wird, wobei eine Abpumpströmung den Materialdampf (34) verteilt und/oder ablenkt.

7. Verfahren nach zumindest einem der vorhergehenden Ansprüche,
**dadurch gekennzeichnet,**
**dass die Verteilung und/oder Ablenkung des Materialdampfes (34) durch Bewe**gung der Materialquelle (28) linear oder exzentrisch rotierend erfolgt und/oder dass der zu beschichtende Gegenstand (20) innerhalb der Prozesskammer (12, 42) in der Materialströmung (38, 48, 64, 86, 96) und/oder dem Materialdampf (34) bewegt wie rotiert, umgewälzt oder linear bewegt wird.

8. Verfahren nach zumindest einem der vorhergehenden Ansprüche,
**dadurch gekennzeichnet,**
**dass** die Verdampfungsquelle (28) diskontinuierlich oder kontinuierlich mit dem zu verdampfenden Material beschickt wird.

## Claims

1. Method for all-round coating of objects (20) subjected in a process chamber (12, 42) to a material vapour and/or mist (34) emitted by a material source (28), the material vapour and/or mist (34) being distributed and/or deflected by active and/or passive means (36, 46, 56, 88, 90, 94) inside the process chamber (12, 42),
wherein
a vacuum permitting a viscous flow is set inside the process chamber (12, 42) having a background gas, wherein a material (32) which is liquid or solid at room temperature and has a vapour pressure > 1 Pa at a temperature of 550 K to 660 K is evaporated in the material source (28) designed as an evaporation source, and wherein the material vapour and/or mist (34) exiting from the at least one evaporation source (28) is distributed and/or deflected together with the background gas by active and/or passive means (36, 46, 56, 88, 90, 94) such that a targeted viscous material flow (38, 48, 64, 86, 96) flowing around the objects (20) on all sides is generated.

2. Method according to Claim 1,
wherein
a medium vacuum in the range from 10 Pa to 100 Pa or a low vacuum above 100 Pa is set inside the process chamber (12) during vapour deposition.

3. Method according to Claim 1 or 2,
wherein
the objects (20) are coated with hydrophobic and/or oleophobic and/or friction-reducing and/or dehesive and/or hydrophilic layers.

4. Method according to at least one of the preceding claims,
wherein
panels (36) in the form of open, sieve-like, perforated, flat or curved planar elements, such as perforated sheets and/or deflecting structures (52, 97) in the form of open, sieve-like, perforated or closed flat or curved planar elements such as perforated sheets or plates, are used as passive means for distributing and/or deflecting the material vapour (34).

5. Method according to at least one of the preceding claims,
wherein
the material flow (38, 48, 64, 86, 96) is generated by gas flows introduced from the outside into the process chamber (12) and/or
wherein gas flows introduced from the outside into the process chamber are used for performance of the method in a low vacuum and/or
wherein the gas flows are admitted via nozzles (56, 58, 60, 62) arranged in annular manner to the material source (28) with their blowing direction radial to the material source designed as an evaporation source and/or
wherein the nozzles (56, 58, 60, 62) are opened successively and individually or in groups with a period in the range from 0.03 s to 120 s, preferably 1 s.

6. Method according to at least one of the preceding claims,
wherein
the material flow (38, 48, 64, 86, 96) is generated by fans and/or blowers (46, 88, 90) arranged inside the process chamber and/or
wherein the material flow (64, 86, 96) is generated by fans and/or blowers (46, 88, 90, 94) in a low vacuum and/or
wherein the material flow (38, 64, 86, 96) is generated by pumping off, the pumping flow distributing and/or deflecting the material vapour (34).

7. Method according to at least one of the preceding claims,
wherein
the distribution and/or deflection of the material vapour (34) is achieved by moving the material source (28) in linear or eccentrically rotating manner and/or wherein the object (20) to be coated inside the process chamber (12, 42) is moved, for example rotated, circulated or moved linearly, in the material flow (38, 48, 64, 86, 96) and/or the material vapour (34).

8. Method according to at least one of the preceding claims,
wherein
the evaporation source (28) is supplied intermittently or continuously with the material to be evaporated.

## Revendications

1. Procédé de revêtement de tous côtés d'objets (20), lesquels sont soumis, dans une chambre de traitement (12, 42), à un matériau en phase vapeur et/ou brouillard (34) provenant d'au moins une source de matériaux (28), le matériau en phase vapeur et/ou brouillard (34) étant diffusé et/ou dévié au moyen d'éléments actifs et/ou passifs (36, 46, 56, 88, 90, 94) à l'intérieur de la chambre de traitement (12,44),
**caractérisé en ce**
**qu'**un vide permettant un écoulement visqueux est ajusté à l'intérieur de la chambre de traitement (12, 42) comprenant un gaz résiduel, qu'un matériau (32) liquide ou solide à une température ambiante et présentant une pression de vapeur > 1 à une température de 550 K à 670 K est vaporisé dans la source de matériaux (28) sous forme de source de vaporisation, et que le matériau en phase vapeur et/ou brouillard (34) sortant d'au moins une source de vaporisation (28) conjointement avec le gaz résiduel est réparti et/ou dévié par les éléments actifs et/ou passifs (36, 46, 56, 88, 90, 94) de sorte qu'il est généré un écoulement de matériaux visqueux (38, 48, 64, 86, 96) dirigé et baignant de tous côtés les objets (20).

2. Procédé selon la revendication 1,
**caractérisé en ce**
**que**, pendant la vaporisation, un vide moyen compris entre 10 Pa et 100 Pa ou un vide grossier supérieur à 100 Pa est ajusté à l'intérieur de la chambre de traitement (12).

3. Procédé selon la revendication 1 ou 2,
**caractérisé en ce**
**que** les objets (20) sont revêtus de couches hydrophobes et/ou oléo-phobes et/ou réduisant la friction et/ou antiadhésives et/ou hydrophiles.

4. Procédé selon au moins l'une des revendications précédentes,
**caractérisé en ce**
**que** des obturateurs (36) sous forme d'éléments ouverts, en forme de passoire, perforés, plans ou courbés plats comme des tôles perforées, et/ou des structures de déviation (52, 97) sous forme d'éléments ouverts, en forme de passoire, perforés ou plats fermés ou courbés plans comme des tôles perforées ou des tôles sont utilisés comme éléments passifs permettant la diffusion et/ou la déviation du matériau en phase vapeur (34).

5. Procédé selon au moins l'une des revendications précédentes,
**caractérisé en ce**
**que** l'écoulement de matériaux (38, 48, 64, 86, 96) est généré par des courants de gaz introduits de l'extérieur dans la chambre de traitement (12) et/ou
**que** les courants de gaz introduits de l'extérieur dans la chambre de traitement lors de l'exécution du procédé sont utilisés sous un vide grossier et/ou
**que** les courants de gaz sont admis par des buses (56, 58, 60, 62) disposées en cercle autour de la source de matériaux (28), le sens de soufflage étant radial par rapport à la source de matériaux conçue sous forme de source d'évaporation (28) et/ou
**que** les buses (56, 58, 60, 62) sont ouvertes individuellement à tour de rôle ou en groupes sur une période comprise entre 0,03 s et 120 s, de préférence d'1 s.

6. Procédé selon au moins l'une des revendications précédentes,
**caractérisé en ce**
**que** l'écoulement de matériaux (38, 48, 64, 86, 96) est généré par des ventilateurs et/ou des souffleurs (46, 88, 90) disposés dans la chambre de traitement et/ou
**que** l'écoulement de matériaux (64, 86, 96) est généré par des ventilateurs et/ou des souffleurs (46, 88, 90, 94) sous un vide grossier et/ou que l'écoulement de matériaux (38, 64, 86, 96) est généré par pompage, sachant qu'un courant de pompage diffuse et/ou dévie le matériau en phase vapeur (34).

7. Procédé selon au moins l'une des revendications précédentes,
**caractérisé en ce**
**que** la diffusion et/ou la déviation du matériau en phase vapeur (34) a lieu en rotation linéaire ou excentrique en raison du mouvement de la source de matériau (28) et/ou
**que** l'objet (20) devant être revêtu à l'intérieur de la chambre de traitement (12, 42) est déplacé en rotation, en boucle ou en linéaire dans l'écoulement de matériaux (38, 48, 64, 86, 96) et/ou le matériau en phase vapeur (34).

8. Procédé selon au moins l'une des revendications précédentes,
**caractérisé en ce**
**que** la source de vaporisation (28) est alimentée en discontinu ou en continu par le matériau devant être vaporisé.
